# EUROPEAN PATENT APPLICATION

(11) **EP 4 742 223 A1**
(43) Date of publication of application: **13.05.2026**
(21) Application number: 23953157.7
(22) Date of filing: 20.09.2023
(51) Int. Cl.: G09F 9/302, G09F 9/33, H01L 25/075

(54) **DISPLAY DEVICE COMPRISING SEMICONDUCTOR LIGHT-EMITTING ELEMENTS, AND METHOD FOR PRODUCING SAME**

(71) Applicant: LG Electronics Inc., Yeongdeungpo-gu Seoul 07336 (KR)
(72) Inventor: AN, Kitae, Seoul 06772 (KR); SHIM, Bongchu, Seoul 06772 (KR)
(74) Representative: Vossius & Partner Patentanwälte Rechtsanwälte mbB
(86) International application number: PCT/KR2023/014219
(87) International publication number: WO 2025/063332

(57) **Abstract**

According to an embodiment, a display device including semiconductor light emitting devices includes a display panel and a frame connected to the display panel. The display panel includes a first display module and a second display module disposed adjacent to each other, each of the first display module and the second display module including a plurality of semiconductor light emitting devices disposed on a substrate, and a seam filling material disposed between the first display module and the second display module. The seam filling material may have a curved surface on one side thereof.

## Description

### [Technical Field]

The present invention relates to a display device including a semiconductor light emitting device and a method for manufacturing the same.

### [Background Art]

Large-area display devices include liquid crystal displays (LCDs), OLED displays, and micro-LED displays.

Micro-LED displays use micro-LEDs, semiconductor light-emitting diodes with a diameter or cross-sectional area of 100um or less, as display elements.

Because micro-LED displays utilize micro-LEDs, semiconductor light-emitting diodes, as display elements, they offer superior performance in many characteristics, including contrast ratio, response speed, color reproducibility, viewing angle, brightness, resolution, lifespan, luminous efficacy, and luminance.

In particular, micro-LED displays offer the advantage of modular separation and combination, allowing for flexible display size and resolution adjustments.

However, large-scale micro-LED displays require millions of micro-LEDs, making it difficult to quickly and accurately transfer micro-LEDs onto display panels.

Recently developed transfer technologies include the pick-and-place process, the laser lift-off method, and the self-assembly method. Among these, the self-assembly method, in which semiconductor light emitting devices autonomously find their assembly positions within a fluid, is advantageous for implementing large-screen display devices.

Conventional display devices using semiconductor light emitting devices are manufactured by transferring them onto substrates such as module substrates or wiring boards. However, this leads to low productivity due to transfer defects in the semiconductor light emitting devices, and the production yield of large-area display devices in particular is extremely low.

To address these issues, research and development are currently underway on a 'multi-screen display device' that implements a large display device by tiling multiple semiconductor light-emitting diode display modules of relatively small size.

However, in the case of multi-screen display devices, gaps may occur between connected unit display devices due to the bezel area at the edge of each unit display device. This gap area exists due to side electrodes (or side wiring) that provide electrical connection between components positioned above and below the substrate.

When a single image is displayed across the entire screen of a multi-screen display device, the gaps or boundary lines between modules may be perceived as "visually recognizable" seams, creating a sense of disconnection and dissonance in the image, thereby reducing the immersive experience.

Techniques for physically or optically obscuring the seams between display modules require changes in process conditions, or the process of removing the seams is performed during the display module manufacturing and bonding stages. This makes it difficult to remove the seams after the display panel is completed.

In addition, after the display panel was completed, changes in the process environment, such as creating a vacuum, were required to remove the seam.

### [Disclosure]

### [Technical Problem]

The technical object of the embodiment is to implement a seamless display device.

Furthermore, the technical object of the embodiment is to implement a process for removing the seam without requiring vacuum conditions.

Furthermore, the technical object of the embodiment is to implement a seamless display device through a simplified process even after the display panel is manufactured.

The technical object of the embodiment is not limited to what is described in this section, but includes what may be understood from the description of the invention.

### [Technical Solution]

According to an embodiment, a display device including semiconductor light emitting devices includes a display panel and a frame connected to the display panel. The display panel includes a first display module and a second display module disposed adjacent to each other, each of the first display module and the second display module including a plurality of semiconductor light emitting devices disposed on a substrate, and a seam filling material disposed between the first display module and the second display module. The seam filling material may have a curved surface on one side thereof.

In addition, in an embodiment, the first display module and the second display module may include a passivation layer disposed on surfaces adjacent to each other, and the seam filling material may include a first region disposed to cover the passivation layer and a second region between the first region.

In an embodiment, the back surface of the first region may have a concave shape.

In addition, in the embodiment, the heights of the first region and the second region may be different from each other.

In addition, in the embodiment, the horizontal width of the seam filling material may be greater than the gap between the first display module and the second display module.

In addition, in the embodiment, the seam filling material may include a hydrophilic material.

In addition, in the embodiment, the frame includes a first frame disposed on the display panel, a second frame disposed on the first frame, and a third frame disposed on the second frame, wherein the gap of the first frame may be smaller than the gap of the second frame, and the gap of the second frame may be smaller than the gap of the third frame.

In addition, according to another embodiment, a method for manufacturing a display device including a semiconductor light emitting device may include the steps of inserting a seam filling tube into a display device including a display panel; contacting the seam filling tube with a seam region of the display panel; injecting a seam filling material into the seam region through the seam filling tube;

removing the seam filling tube; and curing the seam filling material.

In addition, in an embodiment, the seam filling tube may be fixed by a frame of the display device.

In an embodiment, the seam filling tube may be moved while injecting the seam filling material into the seam region.

### [Advantageous Effects]

A display device including a semiconductor light emitting device according to an embodiment has the technical effect of achieving a seamless display even after the display panel is manufactured.

Furthermore, the embodiment has the technical effect of achieving a seamless display without a separate vacuum forming process.

Furthermore, the embodiment has the technical effect of compensating for the flatness and step difference of the seam region and preventing the seam from being physically and optically recognized.

Furthermore, the embodiment has the technical effect of enabling the seam filling tube to be positioned and moved within the display device without using a separate adhesive or fixing device.

The technical effects of the embodiment are not limited to those described herein, but include those understood from the description of the invention.

### [Description of Drawings]

FIG. 1 is an exemplary diagram illustrating a living room of a house in which a display device according to an embodiment is arranged.
FIG. 2 is an enlarged view of the first panel area of the display device of FIG. 1.
FIG. 3 is a cross-sectional view taken along line B1-B2 of area A2 of FIG. 2.
FIG. 4 is an exemplary diagram illustrating a multi-screen display device including multiple display panels according to internal technology.
FIG. 5 is a cross-sectional view of a display panel including a semiconductor light emitting device according to the first embodiment.
FIG. 6 is a cross-sectional view of a display device including a semiconductor light emitting device according to the second embodiment.
FIG. 7 is a conceptual diagram illustrating the seam filling tube of FIG. 6.
FIGS. 8 and 9 are schematic diagrams illustrating a seam filling process according to a third embodiment.
FIGS. 10a to 10d are process diagrams illustrating a seam filling process according to the third embodiment.

### [Mode for Invention]

Hereinafter, the embodiments disclosed in the present specification will be described in detail with reference to the attached drawings. The suffixes 'module' and 'part' used for components in the following description are given or used interchangeably in consideration of the ease of writing the specification, and do not have distinct meanings or roles in themselves. In addition, the attached drawings are intended to facilitate easy understanding of the embodiments disclosed in the present specification, and the technical ideas disclosed in the present specification are not limited by the attached drawings. In addition, when an element such as a layer, region, or substrate is referred to as existing 'on' another element, this includes that it may be directly on the other element, or that other intermediate elements may exist therebetween.

The display devices described in this specification may include digital TVs, mobile phones, smart phones, laptop computers, digital broadcasting terminals, personal digital assistants (PDAs), portable multimedia players (PMPs), navigation devices, slate PCs, tablet PCs, Ultra-Books, desktop computers, and the like. However, the configuration according to the embodiments described in this specification may also be applied to devices capable of displaying, even if they are new product types developed in the future.

A light emitting device and a display device including the same according to an embodiment will be described below.

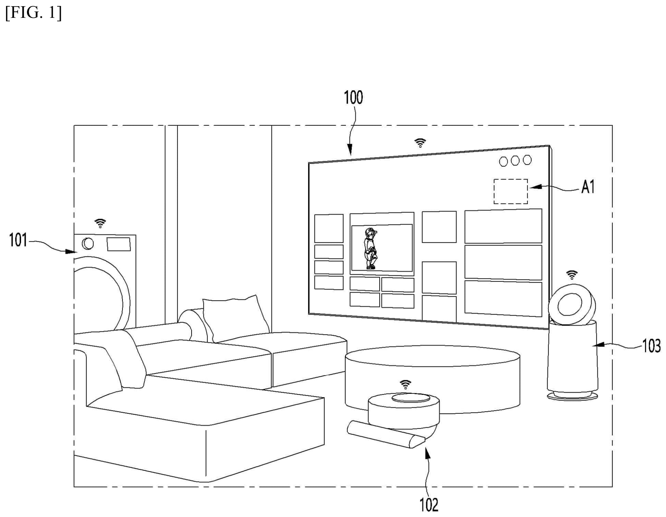

FIG. 1 illustrates a living room of a house in which a display device (100) according to an embodiment is placed.

The display device (100) according to the embodiment may display the status of various electronic products, such as a washing machine (101), a robot vacuum cleaner (102), and an air purifier (103), communicate with each electronic product based on IoT, and control each electronic product based on user setting data.

The display device (100) according to the embodiment may include a flexible display manufactured on a thin and flexible substrate. A flexible display may be bent or rolled like paper while maintaining the characteristics of a conventional flat panel display.

In a flexible display, visual information may be realized by independently controlling the light emission of unit pixels arranged in a matrix. A unit pixel is the minimum unit for displaying a single color. A unit pixel of a flexible display may be implemented by a light emitting device. In an embodiment, the light emitting device may be a Micro-LED or Nano-LED, but is not limited thereto.

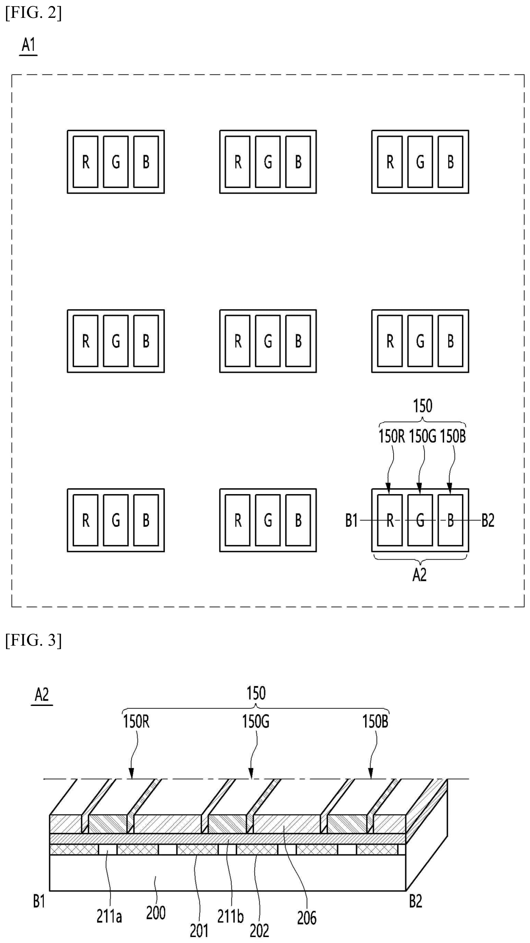

FIG. 2 is an enlarged view of the first panel area (A1) of the display device of FIG. 1.

According to FIG. 2, the display device (100) of the embodiment may be manufactured by mechanically and electrically connecting multiple panel areas, such as the first panel area (A1), through tiling.

The first panel area (A1) may include multiple light emitting devices (150) arranged for each unit pixel (PX of FIG. 2).

For example, the unit pixel (PX) may include a first sub-pixel (PX1), a second sub-pixel (PX2), and a third sub-pixel (PX3). For example, a plurality of red light emitting devices (150R) may be arranged in the first sub-pixel (PX1), a plurality of green light emitting devices (150G) may be arranged in the second sub-pixel (PX2), and a plurality of blue light emitting devices (150B) may be arranged in the third sub-pixel (PX3). The unit pixel (PX) may further include a fourth sub-pixel in which no light emitting devices are arranged, but this is not limited thereto. Meanwhile, the light emitting device (150) may be a semiconductor light emitting device.

Next, FIG. 3 is a cross-sectional view taken along line B1-B2 of area A2 of FIG. 2.

Referring to FIG. 3, the display device (100) of the embodiment may include a substrate (200), assembly wiring (201, 202), a first insulating layer (211a), a second insulating layer (211b), a third insulating layer (206), and a plurality of light emitting devices (150).

The assembly wiring may include a first assembly wiring (201) and a second assembly wiring (202) that are spaced apart from each other. The first assembly wiring (201) and the second assembly wiring (202) are configured to generate a dielectrophoretic force for assembling the light emitting device (150). In addition, the first assembly wiring (201) and the second assembly wiring (202) may be electrically connected to the electrodes of the light emitting device and function as electrodes of the display panel.

The assembly wiring (201, 202) may be formed of a light-transmitting electrode (ITO) or may include a metal material with excellent electrical conductivity. For example, the assembly wiring (201, 202) may be formed of at least one of titanium (Ti), chromium (Cr), nickel (Ni), aluminum (Al), platinum (Pt), gold (Au), tungsten (W), and molybdenum (Mo), or an alloy thereof.

A first insulating layer (211a) may be disposed between the first assembly wiring (201) and the second assembly wiring (202), and a second insulating layer (211b) may be disposed on the first assembly wiring (201) and the second assembly wiring (202). The first insulating layer (211a) and the second insulating layer (211b) may be an oxide film, a nitride film, or the like, but are not limited thereto.

The light emitting device (150) may include a red light emitting device (150), a green light emitting device (150G), and a blue light emitting device (150B0) to form a unit pixel (sub-pixel), but is not limited thereto, and may include a red phosphor and a green phosphor to implement red and green, respectively.

The substrate (200) may be formed of glass or polyimide. In addition, the substrate (200) may include a flexible material such as polyethylene naphthalate (PEN) or polyethylene terephthalate (PET). In addition, the substrate (200) may be a light-transmitting material, but is not limited thereto.

The third insulating layer (206) may include an insulating and flexible material such as polyimide, PEN, PET, etc., and may be formed integrally with the substrate (200) to form a single substrate.

The third insulating layer (206) may be a conductive adhesive layer having adhesive properties and conductivity, and the conductive adhesive layer may be flexible so as to allow the display device to be flexible. For example, the third insulating layer

(206) may be a conductive adhesive layer such as an anisotropic conductive film (ACF) or an anisotropic conductive medium, a solution containing conductive particles, etc. The conductive adhesive layer may be a layer that is electrically conductive in a direction vertical to the thickness, but electrically insulating in a direction horizontal to the thickness.

The third insulating layer (206) may include an assembly hole (203) into which the light emitting device (150) is inserted. Therefore, during self-assembly, the light emitting device (150) may be easily inserted into the assembly hole (203) of the third insulating layer (206). The assembly hole (203) may be referred to as an insertion hole, a fixing hole, an alignment hole, etc.

The spacing between the assembly wirings (201, 202) is formed to be smaller than the width of the light emitting device (150) and the width of the assembly hole (203), thereby enabling the assembly position of the light emitting device (150) to be more precisely fixed using an electric field.

A third insulating layer (206) is formed on the assembly wiring (201, 202) to protect the assembly wiring (201, 202) from the fluid (1200) and prevent leakage of current flowing in the assembly wiring (201, 202). The third insulating layer (206) may be formed as a single layer or multiple layers of an inorganic insulator such as silica or alumina or an organic insulator.

The third insulating layer (206) may also include an insulating and flexible material, such as polyimide, PEN, or PET, and may be formed integrally with the substrate (200) to form a single substrate.

The third insulating layer (206) may be an adhesive insulating layer or a conductive adhesive layer. The third insulating layer (206) may be flexible, thereby enabling a flexible function of the display device.

The third insulating layer (206) may have a partition wall, and an assembly hole (203) may be formed by the partition wall. For example, when forming the substrate (200), a portion of the third insulating layer (206) may be removed, allowing each of the light emitting devices (150) to be assembled into the assembly hole (203) of the third insulating layer (206).

An assembly hole (203) is formed in the substrate (200) to which light emitting devices (150) are coupled, and the surface where the assembly hole (203) is formed may come into contact with a fluid (1200). The assembly hole (203) may guide the precise assembly position of the light emitting device (150).

Meanwhile, the assembly hole (203) may have a shape and size corresponding to the shape of the light emitting device (150) to be assembled at the corresponding position. Accordingly, it is possible to prevent another light emitting device from being assembled in the assembly hole (203) or a plurality of light emitting devices from being assembled.

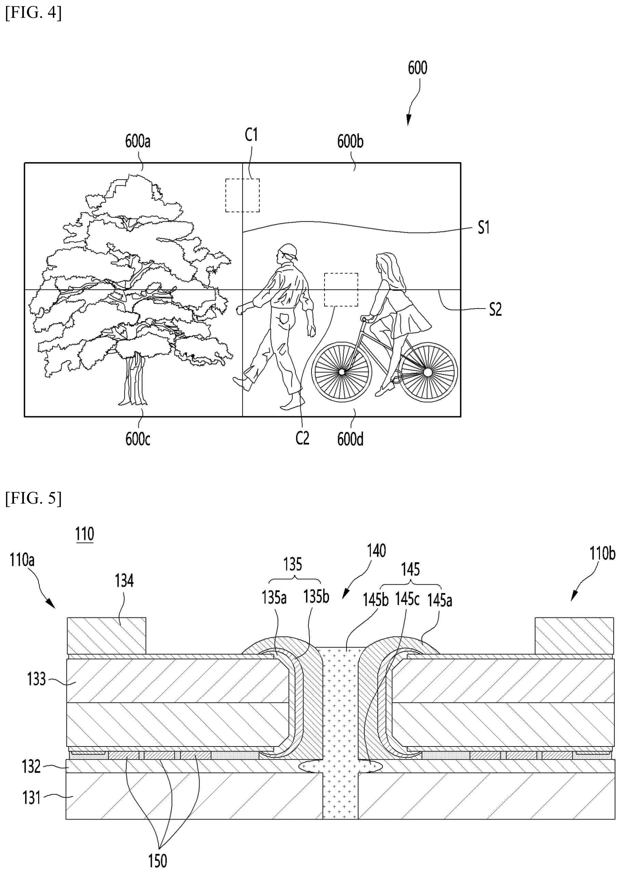

FIG. 4 illustrates a multi-screen display device (600) including a plurality of display panels according to an internal technology.

Referring to FIG. 4, the multi-screen display device (600) may be implemented in a tiled form with a plurality of display panels (600a to 600d). For example, the multi-screen display device (600) may include, but is not limited to, first to fourth display panels (600a, 600b, 600c, 600d). Each of the plurality of display panels (600a to 600d) may be a display device manufactured using the self-assembly method described above, but is not limited thereto.

In the internal technology, the multi-screen display device (600) may be used as a large-area display device that provides a single image through a plurality of display panels (600a to 600d), and each of the plurality of display panels (600a to 600d) may have a minimized bezel area on the side so that the gap area with the adjacent display device may be reduced.

According to the internal technology, as the gap area between the display devices is reduced, the area where dark areas occur due to the gap area when outputting an image may be minimized, and accordingly, an image with a minimized sense of disconnection may be displayed on the entire screen of the multi-screen display device (600).

Meanwhile, referring to FIG. 4, even though the gap, which is the physical distance between multiple display panels, has been reduced, there is an issue in which the gap or boundary line is perceived as a seam (S1) from an optical perspective.

According to the internal technology, the gap between display modules is perceived as a seam due to the gap between the display modules, and the seam is particularly visible when the display device switches to a black state.

Furthermore, according to the internal technology, the presence of a void between the display modules makes it difficult to attach an adhesive layer using OCA or a front cover.

Furthermore, according to the internal technology, the gap (empty space) at the seam when attaching the front cover causes the cover to warp, making the seam more prominent.

Hereinafter, a display device including a semiconductor light emitting device according to an embodiment for solving the above technical problem and a manufacturing method thereof will be described in detail.

FIG. 5 is a cross-sectional view of a display panel (110) including a semiconductor light emitting device according to a first embodiment. Referring to FIG. 5, the display panel (110) may be formed by combining a first display module (110a) and a second display module (110b). Each display module (110a, 110b) may include a cover film (131), a second adhesive layer (132), a TFT substrate (133), and a driving IC (134).

Additionally, a passivation layer (135) may be disposed on one side of the display modules (110a, 110b) facing each other. The passivation layer (135) serves to protect the side wiring connected to the semiconductor light emitting device (150) and may be formed of a material that reduces the visibility of the seam (140). The passivation layer (135) may be formed as a single layer. In addition, the passivation layer (135) may be formed of multiple layers including a first passivation layer (135a) and a second passivation layer (135b).

Meanwhile, a seam (140) exists between the first display module (110a) and the second display module (110b), but a seam filling material (145) may fill the seam (140) through a seam filling tube. The seam filling material (145) may be formed of resin, but is not limited thereto. In addition, the seam filling material (145) may be formed of a black color, but is not limited thereto. The above-mentioned seam filling material (145) may be a hydrophilic material. In addition, the above-mentioned seam filling material (145) may have a refractive index corresponding to the refractive index of the cover film (131) located at the outermost portion.

In addition, the seam filling material (145) may include a first region (145a) covering the passivation layer (135) and a second region (145b) disposed between the first region (145a). The first region (145a) may be in direct contact with the passivation layer (135). The first region (145a) may have a curved surface with a curvature on one side and may have a concave shape.

In addition, the first region (145a) may be positioned between the first display module (110a) and the second display module (110b). The first region (145a) may have an uneven back surface. The horizontal width of the seam filling material (145) may be greater than the horizontal width of the seam (140).

In addition, the heights of the first region (145a) and the second region (145b) may be different.

In addition, the seam filling material (145) may further include a third region (145c) disposed on the second adhesive layer (132). The horizontal width of the third region (145c) may be greater than the horizontal width of the seam (140).

The first region (145a) may prevent problems such as side wiring being exposed or current leakage occurring when the passivation layer (135) is damaged during the process of combining the display modules (110a, 110b).

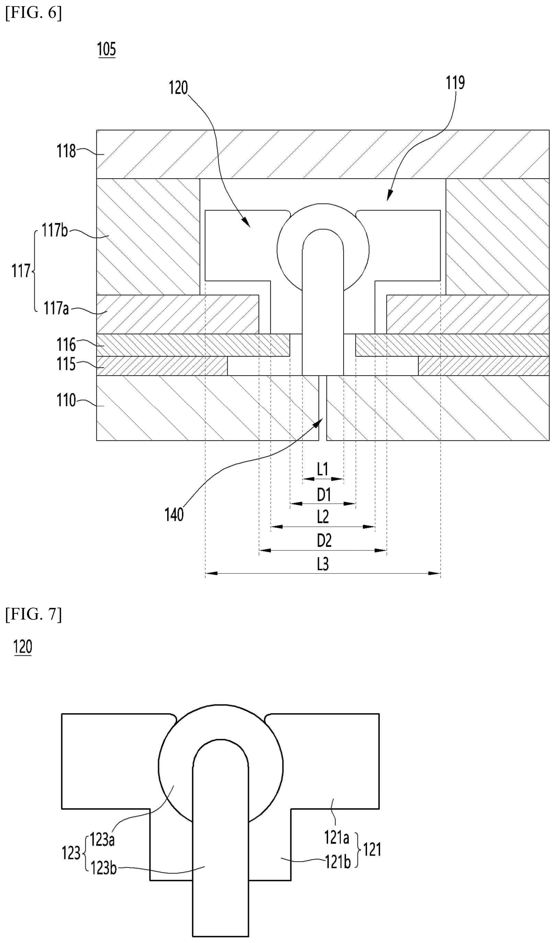

FIG. 6 is a cross-sectional view illustrating a display device including a semiconductor light emitting device according to a second embodiment. The second embodiment may include a display panel including the semiconductor light emitting device of the first embodiment.

Referring to FIG. 6, a display device (105) including a semiconductor light emitting device may include a display panel (110), a first frame (116), a frame fixing member (117), and a second frame (118). The display panel (110) may be adhered to the first frame (116) via a first adhesive layer (115). The first adhesive layer (115) may have adhesive properties on both sides and may be, for example, a double-sided tape. In addition, a seam (140) may be present on the display panel (110).

Meanwhile, a display device (105) including a semiconductor light emitting device may have a hole (119) formed by spacing the first adhesive layer (115), the first frame (116), and the frame fixing member (117) apart from each other inside.

The horizontal width of the hole (119) may vary depending on the height. Meanwhile, a seam filling tube (120) may be arranged within the hole (119). The seam filling tube (120) may be arranged by utilizing a step difference within the display device (105).

Referring briefly to FIG. 7, the horizontal width (L1) of the second nozzle portion (123b) of the seam filling tube (120) may be greater than the horizontal width of the seam (140) of the display panel (110). In addition, the horizontal width (L1) of the second nozzle portion (123b) may be smaller than the horizontal width (D1) of the first frame.

The horizontal width (L2) of the second support portion (121b) of the seam filling tube (120) may be greater than the horizontal width (D1) of the first frame. In addition, the horizontal width (L2) of the second support portion (121a) may be smaller than the horizontal width (D2) of the first frame fixing portion (117a).

The horizontal width (L3) of the first support portion (121a) of the above-described seam filling tube (120) may be greater than the horizontal width (D2) of the first frame fixing portion (117a). In addition, the horizontal width (L3) of the first support portion (121a) may be smaller than the horizontal width of the second frame fixing portion (117b).

Referring again to FIG. 6, accordingly, the seam filling tube (120) may be placed within a hole (119) inside a display device (105) including a semiconductor light emitting device. The seam filling tube (120) may move within the hole (119) as the hole (119) is formed by extending. Therefore, the embodiment has a technical effect in that the seam filling tube (120) is placed within the display device, the nozzle portion contacts the seam (140), and moves while filling the seam (140) with a seam filling material, thereby removing the seam. Furthermore, even without creating a vacuum in the seam (140) within the display panel (110), by injecting a seam filling material after sealing the seam filling tube (120) against the seam (140), the seam is filled by capillary action, thereby simplifying the seamless process without additional equipment or processes such as vacuum condition formation.

FIG. 7 is a schematic diagram of the seam filling tube (120) used in the embodiment. Referring to FIG. 7, the seam filling tube (120) may include a support portion (121) and a nozzle portion (123). The support portion (121) may include a first support portion (121a) having a groove and a second support portion (121b) extending below the first support portion (121a). In addition, the nozzle part (123) may include a first nozzle part (123a) disposed within the groove of the support part (121) and a second nozzle part (123b) disposed to extend from one end of the first nozzle part (123a) along the second support part (121b). The nozzle part (123) may have a long, extended tube shape and may be hollow inside. In addition, the nozzle part (123) is disposed to contact the seam on the back surface of the display panel, and may be used as an outlet for the seam filling material thereafter. The nozzle part (123) may be circular, but is not limited thereto.

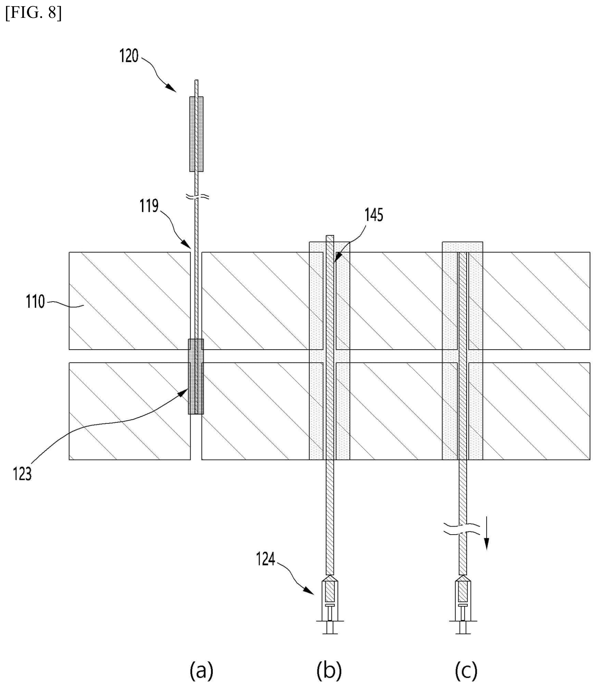

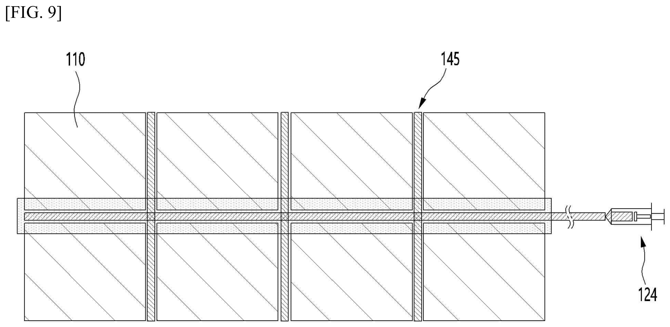

FIGS. 8 and 9 are conceptual diagrams illustrating the process of injecting a seam filler into a display device in which multiple display panels (110) are connected.

Referring to FIG. 8, the seam filler process may be performed in the order of (a), (b), and (c). The multiple display panels (110) may be arranged in a matrix form, and a seam (140) may be present between each display panel.

First, in (a), a seam filler tube (120) may be inserted into a hole (119) of a display panel. The injection port (123) of the seam filler tube may be in contact with the seam in a vertical direction and may move within the hole (119).

Additionally, in (b), a seam filler material (145) may be injected into the seam through the seam filler tube. The seam filling tube may move within the hole (119) while injecting the seam filling material (145) into the seam.

Finally, after the seam filling material (145) is injected in (c), the seam filling tube may be removed. Thereafter, the seam filling material (145) may be hardened and fixed within the seam.

Referring to FIG. 9, the process of injecting the seam filling material of FIG. 8 may also be performed in the horizontal direction of the display panel.

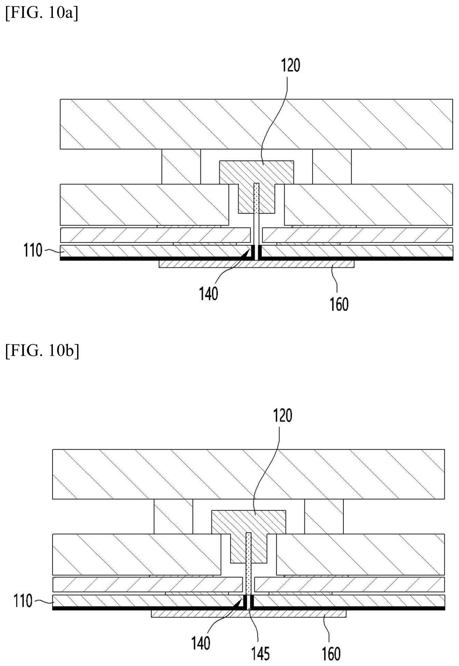

FIGS. 10a to 10d are process diagrams illustrating a process for filling a seam in a display device including a semiconductor light emitting device according to an embodiment.

Referring to FIG. 10a, a protective film (160) is disposed on one surface of a display panel (110) in a display device including a semiconductor light emitting device. The protective film (160) may prevent the seam (140) of the display panel (110) from being opened to the outside. In addition, a seam filling tube (120) is positioned in a hole within the display device. The seam filling tube (120) may be supported by a step within the display device. In addition, the nozzle portion of the seam filling tube (120) may contact the seam (140).

Referring to FIG. 10b, the seam (140) may be filled with a seam filling material (145) through the seam filling tube (120). In addition, the seam filling tube (120) may move while simultaneously filling the seam (140) with the seam filling material (145).

The above-mentioned seam filling material (145) may be resin and may be black in color, but is not limited thereto. Furthermore, the seam filling material (145) may compensate for height differences between the display modules on the display panel (110) and may have a refractive index corresponding to the refractive index of the display panel (110).

Accordingly, the embodiment has the technical effect of a "seamless" structure, whereby the seam (140) is not physically or optically recognized through the seam filling material (145).

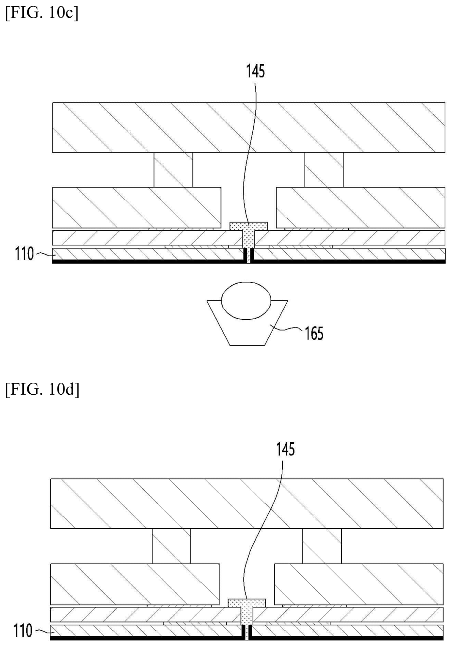

Referring to FIG. 10c, after the seam filling tube is removed from the display device, the seam filling material (145) may be positioned within the seam. Thereafter, the cover film may be removed, and the seam filling material (145) may be heated and cured using a curing device (165). Accordingly, the fluidity of the seam filling material (145) may be removed and fixed within the seam.

Referring to FIG. 10d, the seam filling material (145) may also be formed on the outside of the seam. The seam filling material (145) may be formed to have a concave shape on the outside of the seam, but is not limited thereto.

Accordingly, the embodiment places a seam filling tube within a display device including a semiconductor light emitting device, and fills the seam while moving the nozzle portion in contact with the seam, thereby improving and simplifying the seamless process. The embodiment also has the technical effect of making the seam of the display device physically and optically unrecognizable, thereby enabling a seamless process, and may prevent the occurrence of a step difference by filling the seam after assembling the display module. Furthermore, since the resin is injected through the nozzle, a separate vacuum treatment process is not required, thereby simplifying the seamless process.

A display device including a semiconductor light emitting device according to an embodiment has the technical effect of enabling a seamless display even after the display panel is manufactured.

Furthermore, the embodiment has the technical effect of enabling a seamless display without a separate vacuum forming process.

Furthermore, the embodiment has the technical effect of compensating for the flatness and step difference of the seam region and preventing the seam from being physically and optically recognized.

In addition, the embodiment has the technical effect of allowing the filling tube to be placed and moved within the display device without using a separate adhesive or fixing device.

Although the present invention has been described above with reference to embodiments thereof, it will be readily understood by those skilled in the art that various modifications and changes may be made to the present invention without departing from the spirit and scope of the present invention as set forth in the claims below.

### [Industrial Applicability]

The embodiment may be applied to a display field that displays images or information.

The embodiment may be applied to a display field that displays images or information using semiconductor light emitting devices.

The embodiment may be applied to a display field that displays images or information using micro- or nano-scale semiconductor light emitting devices.

## Claims

1. A display device including semiconductor light emitting devices, comprising:
a display panel; and
a frame connected to the display panel,
wherein the display panel comprises a first display module and second display module disposed adjacent to each other, each of the first display module and the second display module comprising a plurality of semiconductor light emitting devices disposed on a substrate, and a seam filling material disposed between the first display module and the second display module,
wherein the seam filling material has a curved surface on one side thereof.

2. The display device including semiconductor light emitting devices according to claim 1,
wherein the first display module and the second display module comprise passivation layers disposed on surfaces facing each other, and
wherein the seam filling material comprises a first region disposed to cover the passivation layers and a second region disposed between portions of the first region.

3. The display device including semiconductor light emitting devices according to claim 2, wherein a rear surface of the first region has a concave shape.

4. The display device including semiconductor light emitting devices according to claim 2, wherein a height of the first region and a height of the second region are different from each other.

5. The display device including semiconductor light emitting devices according to claim 1, wherein a horizontal width of the seam filling material is greater than a distance between the first display module and the second display module.

6. The display device including semiconductor light emitting devices according to claim 1, wherein the seam filling material comprises a hydrophilic material.

7. The display device including semiconductor light emitting devices according to claim 1, wherein the frame comprises a first frame disposed on the display panel, a second frame disposed on the first frame, and a third frame disposed on the second frame,
wherein a gap of the first frame is smaller than a gap of the second frame, and
wherein the gap of the second frame is smaller than a gap of the third frame.

8. A method for manufacturing a display device including semiconductor light emitting devices, comprising:
inserting a seam filling tube into a display device comprising a display panel;
bringing the seam filling tube into contact with a seam region of the display panel;
injecting a seam filling material into the seam region through the seam filling tube;
removing the seam filling tube; and
curing the seam filling material.

9. The method for manufacturing a display device including semiconductor light emitting devices according to claim 8, wherein the seam filling tube is fixed by a step formed in a frame of the display device.

10. The method for manufacturing a display device including semiconductor light emitting devices according to claim 8, wherein the seam filling tube is configured to move while injecting the seam filling material into the seam region.
